# EUROPEAN PATENT APPLICATION

(11) **EP 1 321 972 A2**
(43) Date of publication of application: **25.06.2003**
(21) Application number: 02020253.7
(22) Date of filing: 10.09.2002
(51) Int. Cl.: H01L 21/027, H01L 21/311

(54) **Trimming process for a structure of photoresist and organic antireflective layer**

(30) Priority: 12.11.2001 US 12291
(71) Applicant: Chartered Semiconductor Manufacturing ,Ltd., Singapore 738406 (SG)
(72) Inventor: Ramachandramurthy, Pradeep Yelehanka, Singapore 760279 (SG); Loong, Loh Wei, Singapore 40416 (SG); Yu, Jie, Singapore 680283 (SG); Qing, Chen Tong, Singapore 70108 (SG)
(74) Representative: Ebner von Eschenbach, Jennifer

(57) **Abstract**

A method for etching an organic bottom antireflective coating (OBARC) and a photoresist material in a single etching process. The method comprises the steps of etching the OBARC and trimming the photoresist material at the same time in an etching environment using a substantially isotropic etching operation. The etching environment including an etching chamber with a top electrode and a bottom electrode wherein a mixture of abrasive gases can flow therethrough. Using an endpoint detection test to determine when an exposed portion of OBARC has been removed, the exposed portion of OBARC being an area of OBARC without photoresist protection and exposed to the etching environment. Applying an over-etch step to trim the photoresist to a desired dimension where the time of the over-etch step being based on the percentage of an endpoint time and the process condition of the over-etch step being same as that of the endpoint step.

## Description

### FIELD OF INVENTION

The present invention relates to the field of semiconductor fabrication. More specifically an embodiment of this invention relates to removal of Organic Bottom Antireflective Coating (OBARC) and photoresist material.

### BACKGROUND OF THE INVENTION

An integrated circuit is an electronic circuit fabricated in a single piece of semiconductor material. The semiconductor surface is subjected to various processing steps in which impurities and other materials are added with specific geometrical patterns. The fabrication steps are sequenced to form three-dimensional regions that act as miniaturized electronic devices, which may include a number of passive and active circuit elements. These devices, whether active or passive, are located on or within a continuous body of material to perform the function of a complete circuit. The term "Integrated Circuit" is often used interchangeably with such terms as microchip, silicon chip, semiconductor chip, microelectronic devices or simply an IC.

Market demands for smaller devices have led the industry to reduce the size of these devices. The limiting factor in the further reduction of the size of integrated circuits is the means for electrically coupling these devices to other electronic components on a printed circuit board, or the inherent electrical limitations on the critical dimensions (CD) of these devices.

To manufacture ICs, a series of imaging, coating, etching, and doping steps are required. The manufacturing processes of an integrated circuit (IC) generally starts with creation of a mask, defining a circuit network image, a photoresist coating, a development process, a critical step of etching, and doping.

A conventional method of etching, when an Organic Bottom Antireflective coating (OBARC) and a photoresist material are used in the masking process, uses a two step operation of a vertical and a lateral etching. The vertical etching, also referred to as an Organic BARC open process, uses an anisotropic process and the lateral etching, also referred to as resist trimming, uses an isotropic process.

The process control in both anisotropic and isotropic processes is based on the length of the time of the etching process. In an OBARC open process, where an anisotropic process is used, the process of OBARC removal continues until a desired volume of OBARC is removed. Once the desired volume of OBARC is removed, time of OBARC removal is measured and this time is used to remove OBARC in a subsequent mass production batches.

The resist trimming process, used to remove photoresist material uses an isotropic process, removing photoresist material in a lateral direction and with an objective of further refining the critical dimension of the devices. Control of the process used in an isotropic process is the same as in an anisotropic process. That is, the process is based on the length of the time to remove a desired volume of photoresist material.

Conventional time based process control in etching uses some environmental parameters as well as parameters relating to the etching chamber's conditions. Some of these parameters may include humidity, temperature, etching chambers' cleanliness, time of etching, ratio of abrasive gases used for etching, residue left on the etching chamber's wall and on the electrodes, etc.... These parameters often change from day to day and, more importantly, they are not tightly controllable. Such process control is not reliable and is subject to many uncontrollable variables.

Process control is a major factor in the fabrication of the integrated circuits. Overetching or underetching in mass production of integrated circuits (ICs) is often very costly. A batch of ICs can be shipped and produce revenue only if there are no flaws in its fabrication. On the other hand, if there are fabrication flaws, impacting the quality of the product, the batch has to be scrapped with no salvage value, thereby creating unwanted expenses. Moreover, the difference between revenue and expense is a mistake in estimating the time of the process by as little as a few fractions of a second.

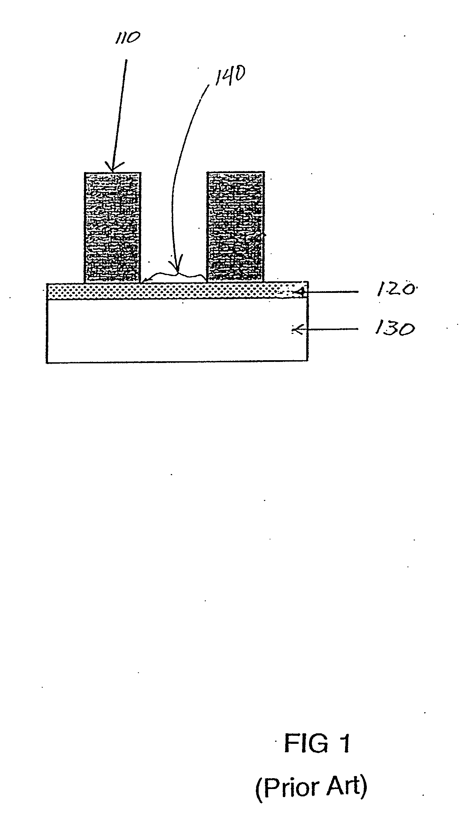

The conventional process control is subject to error due to uncontrollable parameters in the etching process. Prior Art Figures 1, 2, and 3 exemplify lack of control in removing an exact volume of OBARC and photoresist material under the conventional etching process.

Prior Art Figure 1 depicts the initial step in the conventional process of OBARC open and resist trimming. Substrate 130 is covered with a layer of OBARC 120, and photoresist material 110 is selectively applied on top of OBARC material 120. The areas not covered with photoresist material 110 are intended to be etched away during the etching process. Prior Art Figure 1 illustrates OBARC material section 140, as an exemplary section, which is designed to be removed as a result of OBARC open etching process.

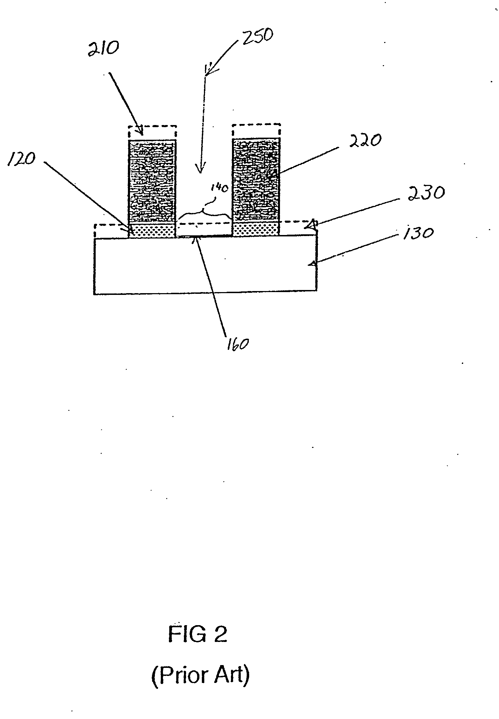

Prior Art Figure 2 is an illustration of the first step in the conventional etching process, OBARC open, wherein an anisotropic process is used for a limited removal of a section of OBARC 140. Open OBARC etching process attacks OBARC 140 in a primarily vertical direction (shown by arrow 250) and removes section 140 of OBARC 120, however, during this process a portion of photoresist material 210 is deleteriously removed. The_portion of photoresist material 210 removed during this first step of the process is neither intended nor a controlled removal from photoresist material 110. The dimension of photoresist material 110 has a direct impact on the critical dimension of an integrated circuit device and any trimming or removal of photoresist material has to be quantifiable and scientifically controlled.

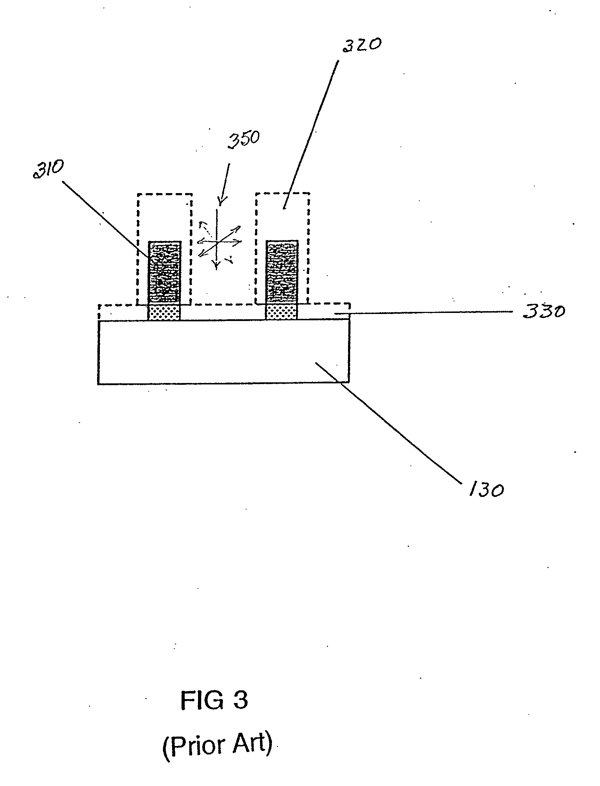

Prior Art Figure 3 illustrates a conventional resist trimming process, a step subsequent to the OBARC open process of Prior Art Figure 2. Prior Art Figure 3 illustrates an isotropic process of photoresist trimming. Isotropic etching process attacks photoresist material 110 from substantially all directions (shown by arrow 350) and trims photoresist in a vertical as well as a lateral direction 320. The control of the process in this step, resist trimming, is again a time-based process. Thus, the conventional etching process removes photoresist material 110 in two unquantifiable steps. In the first step, OBARC open, a vertical removal of photoresist takes place without intent, and then in the second step of resist trimming a vertical removal as well as lateral removal based on unreliable time based process control.

The control of OBARC removal and photoresist removal during both processes, OBARC open and resist trimming, is based on the time length of the processes. Prior Art Figure 3 illustrates that photoresist material is removed (see area 320), leaving photoresist material 310. However, a portion of photoresist material 210 was removed without intent in the first step of the process and some more during the second process, what remains of photoresist material 310 is subject to error in both processes, due to lack of control in both steps of the processes.

Thus, a need exists for an efficient method of controlling the process of photoresist material removal which is quantifiable and is a scientific way of controlling such a delicate process rather than solely relying on time of the process which may change from day to day.

### SUMMARY OF THE INVENTION

Accordingly, an efficient method of controlling the process of OBARC and photoresist material removal is disclosed. The present invention provides a quantitative method for measuring the desired level of OBARC and photoresist is presented. The present invention provides a quantifiable method, which remains stable and does not change operation from day to day once all parameters are considered.

More specifically, in one embodiment, the preseent invention provides a method for etching an organic bottom antireflective coating (OBARC) and a photoresist material in a single etching process. The method comprises the steps of etching the OBARC and trimming the photoresist material at the same time in an etching environment using a substantially isotropic etching operation. In this embodiment, the etching environment including an etching chamber with a top electrode and a bottom electrode wherein a mixture of abrasive gases can flow. In one embodiment, an endpoint detection test is used to determine when an exposed portion of OBARC has been removed, the exposed portion of OBARC being an area of OBARC without photoresist protection and exposed to the etching environment. Applying an over-etch step to trim the photoresist to a desired dimension where the time of the over-etch step being based on the percentage of an endpoint time and the process condition of the over-etch step being same as that of the endpoint step.

These and other objects and advantages of the present invention will become obvious to those of ordinary skill in the art after reading the following detailed description of the preferred embodiment which are illustrated in the drawing figures.

### BRIEF DESCRIPTION OF THE DRAWINGS

The accompanying drawings, which are incorporated in and form a part of this specification, illustrate embodiment of the invention and, together with the description, serve to explain the principles of the invention:

Prior Art Figure 1 depicts an application of photoresist and OBARC on a substrate film.

Prior Art Figure 2 is an illustration of a traditional OBARC open, a vertical removal of OBARC and photoresist.

Prior Art Figure 3 illustrates a traditional photoresist removal subsequent to the OBARC open of Figure 2.

Figure 4 illustrates resist patterning in an etching process performed in accordance with one embodiment of the present claimed invention.

Figure 5 is an illustration of a combined OBARC open and photoresist removal performed in accordance with one embodiment of the present claimed invention.

Figure 6 is a flow chart of steps performed in an exemplary etching process wherein a combined anisotropic and an isotropic process using an endpoint detection method is used in accordance with one embodiment of the present invention.

Figure 7 is a flow chart of an embodiment of the present invention allowing a widening of a process window, resulting in further resist trimming to achieve a narrower critical dimension in accordance with one embodiment of the present invention.

The drawings referred to in this description should not be construed as being drawn to scale except when specifically noted.

### DETAILED DESCRIPTION OF THE PREFERRED EMBODIMENTS

Reference will now be made in detail to preferred embodiment of the invention, a method for organic bottom antireflective coating (OBARC) and photoresist trimming process, examples of which are illustrated in the accompanying drawings. While the invention will be described in conjunction with the preferred embodiments, it will be understood that they are not intended to limit the invention to these embodiments. On the contrary, the invention is intended to cover alternatives, modifications, and equivalents, which may be included within the spirit and scope of the invention as defined by the appended claims. Furthermore, in the following detailed description of the present invention, numerous specified details are set forth in order to provide a thorough understanding of the present invention. However, it will be obvious to one of ordinary skill in the art that the present invention may be practiced without these specific details. In other instances, well known methods, and circuits have not been described in detail as not to unnecessarily obscure aspects of the present invention.

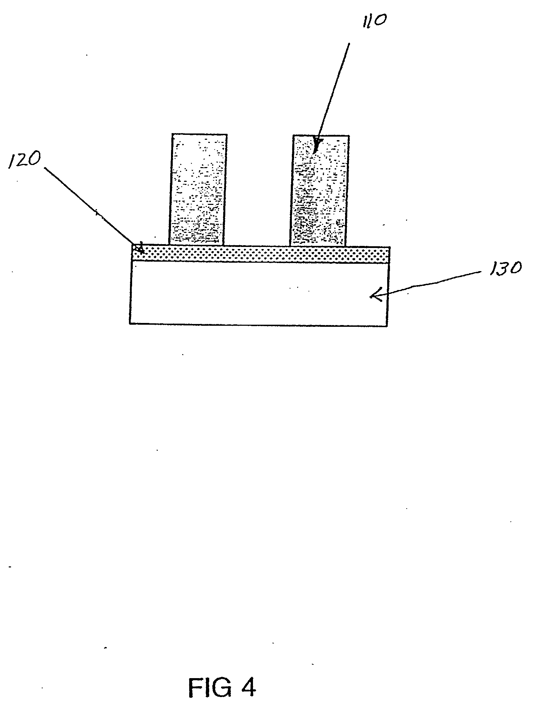

Figure 4 illustrates an application of photoresist 110 and OBARC 120 on a substrate film, in preparation for a combined OBARC open and resist trimming. A combined OBARC open and photoresist trimming is applied by using a substantially isotropic etching process to remove OBARC 120 and photoresist 110 in substantially all directions. A one step endpoint detection, in conjunction with an over-etch step, is used to determine achieving the desired critical dimension.

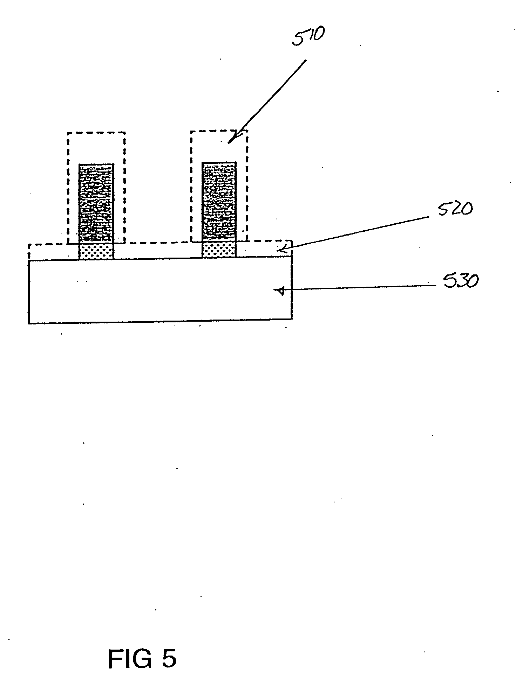

Figure 5 is an illustration of a combined OBARC open and resist trimming processes performed in accordance with one embodiment of the present invention. According to this embodiment of the present invention an isotropic process is used to remove OBARC material 120 and photoresist material 110 in substantially all directions. This one step isotropic removal of OBARC material 120 and photoresist material 110 is followed by an over-etch step with the same recipe content to achieve removing OBARC material 120 and photoresist material 110 to a desired level measured by a single endpoint detection test.

It is appreciated that Figure 5 is distinguished from Prior Art Figure 3. In Prior Art Figure 3, portion of photoresist material 210 is removed without intent to remove that portion and with time based process control. The critical dimension is defined with time based process control as well. In Figure 5, removal of photoresist material 110 and control of critical dimension are based on endpoint detection test, which give a reliable scientific measure of controlling the process.

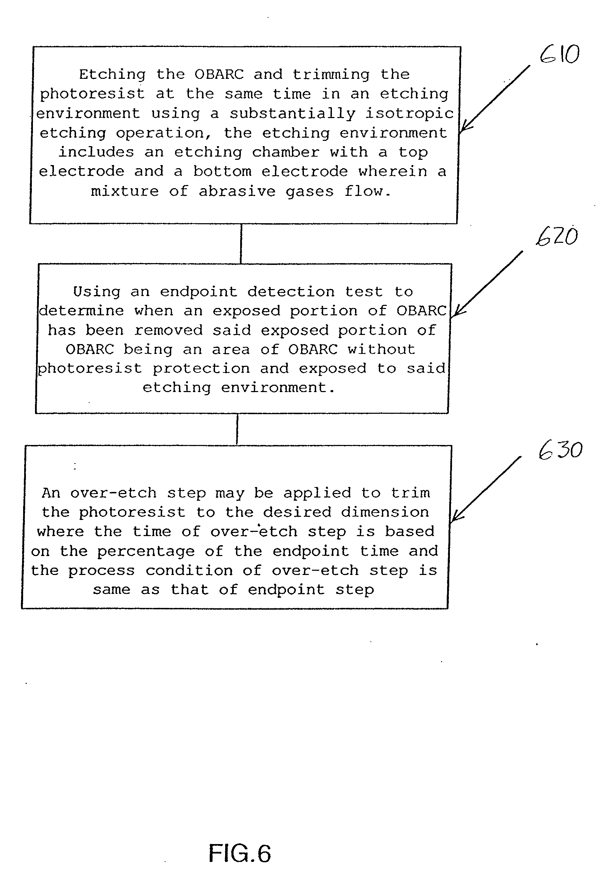

Figure 6 is a flow diagram of an exemplary process 600 wherein a combined anisotropic and an isotropic etching process using an endpoint detection method is used.

In step 610, etching the OBARC and trimming the photoresist at the same time in an etching environment using a substantially isotropic etching operation, the etching environment includes an etching chamber with a top electrode and a bottom electrode wherein a mixture of abrasive gases flow.

In step 620, Using an endpoint detection test to determine when an exposed portion of OBARC has been removed said exposed portion of OBARC being an area of OBARC without photoresist protection and exposed to said etching environment.

In step 630, an over-etch step may be applied to trim the photoresist to the desired dimension where the time of over-etch step is based on the percentage of the endpoint time and the process condition of over-etch step is same as that of endpoint step

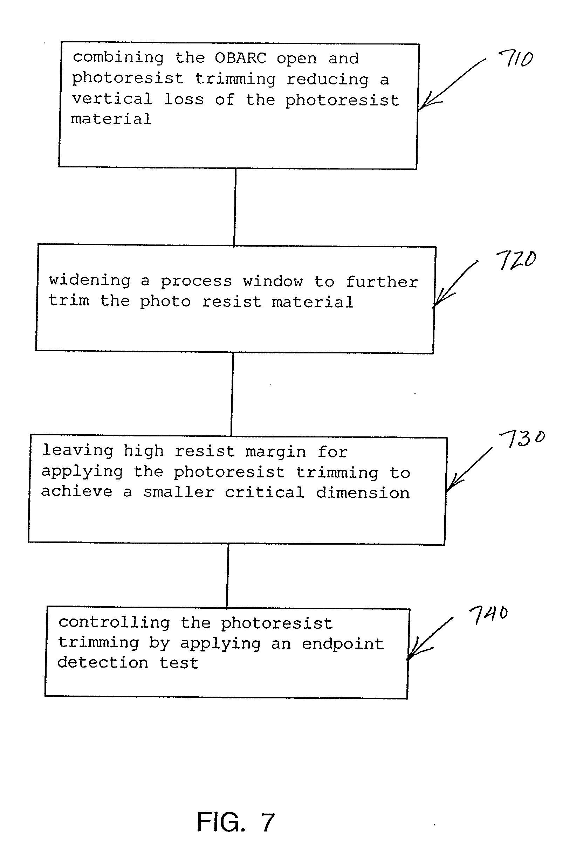

Figure 7 is a flow diagram of process 700, wherein an embodiment of the present invention allows a widening of the process window, resulting in further resist trimming to achieve a narrower critical dimension.

In step 710, combining the OBARC open and photoresist trimming reducing a vertical loss of the photoresist material.

In step 720, widening a process window to further trim the photo resist material.

In step 730, leaving high resist margin for applying the photoresist trimming to achieve a smaller critical dimension.

In step 740, controlling the photoresist trimming by applying an endpoint detection test.

Thus, the present invention provides an efficient method of controlling the process of OBARC and photoresist material. The present invention further provides a quantitative method for measuring the desired level of OBARC and photoresist removal. Furthermore, in the present invention process remains stable and operation does not change from one day to the next.

The foregoing descriptions of specific embodiments of the present invention have been presented for the purpose of illustration and description. They are not intended to be exhaustive or to limit the invention to the precise form disclosed, and obviously many modifications and variations are possible in light of the above teaching. The embodiments were chosen and described in order to best explain the principles of the invention and its practical application, to thereby enable others skilled in the art to best utilize the invention and various embodiments with various modifications and suited to the particular use contemplated. It is intended that the scope of the invention be defined by the Claims appended hereto and their equivalents.

## Claims

1. A method for etching an organic bottom antireflective coating (OBARC) and a photoresist material in a single etching process, said method comprising the steps of:
a) etching said OBARC and trimming said photoresist material at the same time in an etching environment using a substantially isotropic etching operation, said etching environment including an etching chamber with a top electrode and a bottom electrode wherein a mixture of abrasive gases can flow therethrough;
b) using an endpoint detection test to determine when an exposed portion of OBARC has been removed, said exposed portion of OBARC being an area of OBARC without photoresist protection and exposed to said etching environment; and
c) applying an over-etch step to trim said photoresist to a desired dimension where the time of said over-etch step is based on the percentage of an endpoint time and the process condition of said over-etch step is same as that of said endpoint step.

2. The method as recited in Claim 1, wherein said endpoint detection test of step b) is used to determine a time length for said OBARC removal.

3. The method as recited in Claim 1 wherein said bottom electrode applies a power between 10-80 W.

4. The method as recited in Claim 1 wherein said endpoint detection test detects said substrate material etched away in said etching chamber.

5. The method as recited in Claim 1 wherein said endpoint detection test detects a ratio of said exposed portion of said OBARC and said photoresist material in said etching chamber.

6. The method as recited in Claim 1 wherein a mixture of abrasive gases flows inside said etching chamber; said mixture of abrasive gases including, O² and Cl2, CF4, HBr, HI, SO.

7. The method as recited in Claim 6 wherein said mixture of abrasive gases flowing inside said etching chamber maintains a varying ratio of O² to said other gases included in said mixture of abrasive gases;

8. The method as recited in Claim 7 wherein volume of said O² in said ratio varies between 20-80 percent.

9. The method as recited in Claim 6 wherein removal of said OBARC and said photoresist material is achieved by a change in said ratio of said abrasive gases in conjunction with a change in said bottom electrode power controls.

10. The method as recited in Claim 6 wherein said endpoint detection test detects etched material in said etching chamber.

11. The method as recited in Claim 6 wherein a ratio of the O² to the rest of said gases flowing through an etching chamber varies between 20-80 percent.

12. The method as recited in Claim 6 wherein said transfer from said anisotropic process to said isotropic process being controlled by changes in said ratio of O² to said other gases and changes in bias power applied to said bottom electrode.

13. The method as recited in Claim 12 wherein said changes in said ratio of O2 to said other gases is by increasing the O² and changes in power applied to said bottom electrode is by lowering the bottom electrode power.

14. A method for etching an organic bottom antireflective coating (OBARC) and a photoresist material in a single etching process, said method comprising the steps of:
a) combining an OBARC open and a photoresist trimming to reduce a vertical loss of said photoresist material;
b) widening a process window to further trim said photoresist material;
c) leaving high resist margin for applying said isotropic photoresist material removal process to achieve a smaller critical dimension; and
d) controlling said photoresist trimming by applying an endpoint detection test.

15. The method as recited in Claim 14 wherein a controlled transfer from said anisotropic process to said isotropic process reduces a vertical loss of said photoresist material.

16. The method as recited in Claim 14 wherein said widening of said process window allows further resist trimming to further refine said critical dimension.
